# EUROPÄISCHE PATENTSCHRIFT

(11) **EP 3 394 640 B1**
(45) Veröffentlichungstag und Bekanntmachung des Hinweises auf die Patenterteilung: **28.04.2021**
(21) Anmeldenummer: 16829061.7
(22) Anmeldetag: 02.12.2016
(51) Int. Cl.: G01T 1/164, G01T 1/208, G01T 1/24

(54) **SIPM-SENSORCHIP**
SIPM SENSOR CHIP
PUCE DE CAPTEUR DE PHOTOMULTIPLICATEUR EN SILICIUM

(30) Priorität: 21.12.2015 DE 102015016471; 19.05.2016 DE 102016006056
(43) Veröffentlichungstag der Anmeldung: 31.10.2018
(73) Patentinhaber: Forschungszentrum Jülich GmbH, 52425 Jülich (DE)
(72) Erfinder: BERNEKING, Arne, 52062 Aachen (DE); SHAH, Nadim Joni, 52428 Jülich (DE); LERCHE, Christoph, 52134 Herzogenrath (DE)
(86) Internationale Anmeldenummer: PCT/DE2016/000428
(87) Internationale Veröffentlichungsnummer: WO 2017/108018

(56) Entgegenhaltungen:
- EP-A2- 2 495 585
- WO-A1-2015/063704
- FERRI ALESSANDRO ET AL: "Characterization of Linearly Graded Position-Sensitive Silicon Photomultipliers", IEEE TRANSACTIONS ON NUCLEAR SCIENCE, IEEE SERVICE CENTER, NEW YORK, NY, US, Bd. 62, Nr. 3, 1. Juni 2015 (2015-06-01), Seiten 688-693, XP011584227, ISSN: 0018-9499, DOI: 10.1109/TNS.2015.2396671 [gefunden am 2015-06-12]

## Beschreibung

Nach dem Stand der Technik werden Positronen-Emissions-Tomographie-Detektorringe eingesetzt um die β⁺β⁻ Annihilationsstrahlung zu detektieren. Die Ringe bestehen aus Szintillationskristallen an die Sensoren angrenzen, die dazu in der Lage sind die Szintillationsstrahlung zu detektieren. Typische Detektoren sind SiPM (Silizium Photomultiplier). Der Aufbau gestaltet sich derart, dass der Detektorring in der Regel kreisförmig ist, wobei das zu vermessende Objekt, beispielsweise ein Körperteil eines Patienten oder Tieres in das Zentrum des Detektorrings (PET-Ring) gelegt wird. Durch die Verwendung von Radiodiagnostika wird β⁺β⁻ Annihilationsstrahlung erzeugt, die detektiert werden soll. Die β⁺β⁻ Annihilationsstrahlung, im Folgenden Vernichtungsstrahlung genannt, trifft auf Szintillationskristalle, die ringförmig um das zu untersuchende Objekt angeordnet sind und erzeugt die Szintillationsstrahlung. Die Szintillationsstrahlung wird wiederum von den SiMP registriert, die sich bezogen auf die Strahlungsquelle, in der konzentrischen Anordnung hinter dem Szintillationskristall befindet. Die SiMP können jedoch auch an anderen Seiten des Szintillationskristalls angeordnet sein, beispielsweise vor dem Szintillationskristall oder seitlich davon. Der Szintillationskristall ist ein dreidimensionaler Körper. Bezogen auf eine Anordnung, bei der das zu untersuchende Objekt vom Zentrum des Detektorrings Vernichtungsstrahlung emittiert, spannt der Querschnitt auf den die Vernichtungsstrahlung auf den Szintillationskristall trifft, eine xy-Achse auf. Die Tiefe des Szintillationskristalls wird in dieser Nomenklatur als z-Achse bezeichnet. In einer idealisierten Darstellung befindet sich im Zentrum des Detektorrings ein zu untersuchendes Objekt bzw. eine Emissionsquelle für Strahlung einer Energie von 511 keV, die idealerweise senkrecht auf die xy-Ebene des Szintillationskristalls trifft und eine Eindringtiefe entlang der z-Achse des Szintillationskristalls aufweist. Die 511keV Vernichtungsstrahlung löst dann an einem Punkt des Szintillationskristalls entlang der z-Achse eine Szintillation aus, die vom Sensor, beispielsweise einem SiPM, als Signal registriert wird. Ein SiPM ist fähig sogar einzelne Photonen zu detektieren. Wenn das minimal benötigte Licht auf die aktive Sensorfläche trifft, erfährt die SiPM-Mikrozelle einen Durchbruch der Diode. Dies generiert einen Strompuls, welcher am Ausgang des Bauteiles gemessen werden kann. Ein sogenannter Quench-Widerstand verhindert, dass die Zelle einen kritischen Strom generiert, der so hoch wird, dass das Bauteil zerstört wird. Der Ausgangsstrom einer SiPM-Mikrozelle ist unabhängig von der Menge Licht, welche den Sensor erreicht und den Durchbruchprozess gestartet hat. Eine SiPM-Mikrozelle ist ein binärer Sensor, der detektiert, ob Licht einfällt oder nicht. Um quantitative Informationen über das einfallende Licht zu erhalten, besteht ein SiPM aus einer Vielzahl von Mikrozellen. Eine Mikrozelle besteht dabei aus einer Photodiode und einem Quenchwiderstand. Die Anzahl der durchgebrochenen Zellen gibt dann Informationen über die eingefallene Lichtmenge an.

Es besteht ein Zusammenhang zwischen der Sensitivität des Szintillationskristalls und dessen Länge entlang der z-Achse. Je tiefer der Szintillationskristall dimensioniert ist, desto empfindlicher ist er, da es umso wahrscheinlicher zu einem Szintillationsereignis kommt. Bei der Detektion der Vernichtungsstrahlung werden von dem Punkt, an dem die Vernichtungsstrahlung emittiert wird, Strahlen in zwei entgegengesetzte Richtungen emittiert, so dass die Strahlen einen Winkel von 180° ausbilden. Die Linie, die durch diese Strahlen gebildet wird, wird als "line of response" (LOR) bezeichnet. Entsprechend treffen bei einem ringförmigen Detektor entlang der LOR zwei Strahlen auf Szintillationskristalle, die - bezogen auf die ringförmige Anordnung in deren Zentrum sich die Emissionsquelle befindet - auf gegenüberliegenden Seiten liegen.

Für Detektoren mit einer Lichtdetektion durch Photodioden in Form von SiPMs an nur einer Seite des Szintillatioskristalls existieren verschiedene etablierte Methoden, um die x- und y-Position eines Events zu bestimmen. Diese beinhalten jedoch nicht die z-Position und somit ist nicht die genau Position im Szintillationskristall bestimmt, wo das Gammaphoton auf der z-Achse gestoppt und in Licht umgewandelt wurde. Wird die z-Position nicht mit bestimmt, kommt es bei der Bestimmung der LOR zu parallaxen Fehlern, die auf das sogenannte Interaktionstiefenproblem (DOI-Problem) zurückzuführen sind. Das DOI-Problem kommt immer dann zu Stande, wenn der Punkt, von dem die Emission der Vernichtungsstrahlung ausgeht in einem ringförmigen Detektor nicht genau im Zentrum liegt. Je weiter sich das Emissionszentrum für eine LOR außerhalb des Zentrums eines PET-Rings befindet, desto größer wird das Problem. Dadurch kommt es beim Design eines PET-Ringes zu einem Kompromiss zwischen Erhöhung der Sensitivität durch längere Szintillationskristalle und Verringerung der DOI-Fehler durch kürzere Szintillationskristalle. In einigen Bereichen der PET-Anwendung besteht der Bedarf, eng am Untersuchungsobjekt anliegende PET-Ringe (Detektorringe) zu verwenden. Das ist insbesondere in der Medizin der Fall, wenn Patienten gleichzeitig mit einem MRT-Verfahren und einem PET-Verfahren untersucht werden sollen. Dann muss der PET-Ring in die Öffnung der MRT-Scannerröhre passen. Das hat zur Folge, dass der verwendete PET-Ring im Durchmesser klein dimensioniert sein muss, damit er in die Öffnung des MRT-Rings passt. Bei einer kleinen Dimensionierung des PET-Rings besteht jedoch das Problem, dass das zu untersuchende Objekt, beispielsweise ein Körperteil eines Kleintiers oder auch eines Menschen, zwar zentriert angeordnet werden kann, jedoch gemessen an dem Durchmesser des PET-Rings so dimensioniert ist, dass er bis weit in die Randbereiche der Öffnung des PET-Rings reicht. Damit sind jedoch auch Punkte, von denen Vernichtungsstrahlung ausgeht so dicht am PET-Ring positioniert, dass das DOI-Problem erheblich wird.

In den vergangenen Jahren wurde insbesondere die Auflösung bei Kleintier-PET-Scannern mit der Verwendung von pixilierten Szintillationskristallblöcken mit immer kleineren Pixelgrößen deutlich verbessert. Dabei ist die Pixelung auf der xy-Ebene verwirklicht, so dass sich im Szintillationskristall Röhren von Pixeln, die in z-Richtung ausgerichtet sind, ausbilden. Dies wurde besonders durch den Bedarf an immer höherer Ortsauflösung in Kleintier-PET-Scannern gefördert, da das untersuchte Objekt sehr klein ist. Mittlerweile hat die Pixelgröße bereits den Submillimeterbereich erreicht. Deswegen kommt es verstärkt zu zwei Problemen, die gelöst werden müssen. Erstens bestehen die pixilierten Kristallblöcke aus Kleber und Reflektorfolie, welche sich zwischen den einzelnen Szintillationskristallen befindet, um so den pixilierten Block aufzubauen. Die Schicht Kleber und Reflektorfolie hat eine ungefähre Dicke von 70µm. Demzufolge haben pixilierte Arrays mit besonders geringem Pixelabstand einen erhöhten Sensitivitätsverlust. Im Falle eines Arrays mit 0.8 cm x 0.8 cm großen Kristallpixeln, wie sie zum Beispiel in [1] verwendet wurden, verringert sich das Verhältnis von Kleber und Folie zu Szintillationskristall deutlich, so dass Kleber und Folie bereits einen Anteil von 29 % ausmachen. Der Szintillationskristallanteil ist folgerichtig auf 71 % reduziert. In den anderen 29 % Volumen können keine Gammaquanten gestoppt und in Licht umgewandelt werden. Verwendet man noch kleinere pixilierte Arrays von beispielsweise 0.5 cm x 0.5 cm, reduziert sich der Kristallanteil sogar auf 59 %. Deswegen ist die Erhöhung der Auflösung mit pixilierten Arrays immer an einen Verlust von Sensitivität gebunden. Das zweite Problem mit pixilierten Szintillationskristallarrays ist, dass das emittierte Licht auf einen kleineren Bereich der SiPM-Detektorfläche konzentriert wird. Ein SiPM besteht aus mehreren Mikrozellen, welche als binäre Elemente funktionieren. Sie detektieren, ob Licht detektiert wurde oder nicht. Wird Licht detektiert vollzieht die Mikrozelle einen Durchbruch. Die Anzahl der durchgebrochenen Mikrozellen geben quantitativ an, wie viel Licht die Detektoroberfläche erreicht hat. Wenn zwei oder mehr Lichtquanten eine Mikrozelle triggern, bleibt das Ausgangssignal gleich. Je mehr Licht einen SiPM trifft, umso höher ist die Wahrscheinlichkeit, dass zwei oder mehr Lichtquanten auf die gleiche Mikrozelle des SiPM treffen. Diese zusätzlichen Lichtquanten können dann nicht detektiert werden. Konsequenter Weise ist die Wahrscheinlichkeit von Sättigung einer Mikrozelle deutlich höher, wenn pixilierte Szintillationskristallarrays verwendet werden, da diese das Licht stärker auf einen kleinen Bereich des Sensors konzentrieren. Sättigungseffekte führen auch zu einer schlechteren Energieauflösung der Detektoren.

Wie eingangs erwähnt verwenden Detektoren vom Stand der Technik SiPM-basierte Sensortechnologien, um Magnetresonanztomographiekompatibilität (MRI-Kompatibilität) für den Gebrauch in MR/PET Hybridscannern zu ermöglichen. Ein weiteres Problem mit Hybridscannern ist, dass der Platz für PET-Detektoren und zugehörige Elektronik durch den Röhrendurchmesser des Magnetresonanztomographens (MRT) begrenzt ist. Dies trifft insbesondere für Ultra-Hochfeld-Tomographen zu. Als Konsequenz des schmaleren Röhrendurchmessers müssen die PET-Szintillationskristalle so kurz wie möglich sein. Kürzere Szintillationskristalle verringern ebenfalls die Sensitivität. Die bedeutet auch, dass sich durch die Bedingungen des Röhrendurchmessers der PET-Ring näher am Untersuchungsobjekt befindet. Der parallaxe Fehler ist umso größer, je näher die Annihilationen und damit die resultierenden LOR am PET-Ring stattfinden. Dies liegt daran, dass die Gammaquanten nicht mehr senkrecht in die Szintillationskristalle einfallen, wenn die Annihilation nahe am PET-Ring ereignet. Dies hat im PET-Ringdesign die Folge, dass die parallaxen Fehler zunehmen und stärker werden, wenn der PET-Ring sich nahe am zu untersuchenden Objekt befindet, da in diesem Fall Annihilation ebenfalls nahe am PET-Ring stattfinden können. Abgesehen von Beschränkungen durch Hybridgeräte versucht man auch auf Grund einer höheren Sensitivität und geringerer Kosten die PET-Ringe so schmal wie möglich zu entwerfen.

Weiterhin ist bekannt, dass viele SiPM-Sensorkonzepte eine Kodierung der Ausgangskanäle beinhalten, da durch die Erhöhung der Ausgangskanäle die Leistungsaufnahme des PET-Ringes erhört wird. Diese ist allerdings konstruktionsbedingt limitiert. Eine einfache Rechnung verdeutlicht dies. Ein PET-Ring mit einem Durchmesser von 8 cm und einer Länge von 10 cm resultiert in einer Detektoroberfläche von 251 cm². Wird eine 1-zu-1-Kopplung von Szintillationskristallen und SiPMs mit einer Kristallpixelgröße von 0.8 mm verwendet, werden bereits 39270 Auslesekanäle benötigt, falls jeder Kanal individuell ausgelesen wird.

Um höhere Ortsauflösungen zu erzielen, bestehen aktuelle Sensordesigns aus Sensorchips mit schmaleren Pixelgrößen. Dies führt zu einer deutlichen Erhöhung der Auslesekanäle, welche durch die Leistungsaufnahme, Platz und Datenraten begrenzt sind. Als Konsequenz daraus wurden positionssensitive (PS) Kodierungsmethoden entwickelt, um die Anzahl der Auslesekanäle eines Chips zu reduzieren [1-3, 15]. Das aktuellste entwickelte Konzept heißt PS-SSPM [1] und basiert auf ladungsteilenden PS-SiPMs. Ladungsteilenden PS-SiPM-Mikrozellen detektieren das Licht wie herkömmliche SiPM-Mikrozellen. Jedoch beinhaltet dieses Sensorkonzept ein Widerstandsnetzwerk, welches die generierte Ladung abhängig von der Position und der Kodierung verteilt. Der in [1] vorgestellte Detektoraufbau besteht aus einem pixilierten Kristallarray mit einem Abstand von 0.8 mm.

Dieses aktuellste Detektorkonzept ermöglicht den Vorteil einer Ausgangskanalreduzierung durch die Kanalkodierung bei gleichzeitiger hoher Detektorarrayauflösung, welche durch den Gebrauch von pixilierten Szintillationskristallarrays mit einem Abstand von weniger als einem Millimeter erreicht wird. Allerdings beinhaltet es keine DOI-Informationsdetektion.

Ein in [4] publiziertes Konzept beweist die Möglichkeit einen PET-Detektor bestehend aus monolithischen Kristallen und SiPMs aufzubauen. Wie bereits zuvor erwähnt, lösen monolithische Kristalle das Problem von Sensitivitätsverlusten durch den Platzbedarf von Reflektorfolien und zugehörigen Klebern. Außerdem fallen dadurch die Produktionskosten von monolithischen Kristallen geringer aus. Die verwendete Dicke der Kristalle beträgt 2mm. Dadurch werden mit dem in [4] verwendeten Aufbau parallaxe Fehler vermieden, was jedoch durch die geringe Ausdehnung des Szintillationskristalls in z-Richtung erkauft wird. Gleichzeitig ist die Detektionseffizienz durch die geringe Kristallhöhe jedoch gering.

Es gibt verschiedene Möglichkeiten DOI-Informationen zu messen und damit parallaxe Fehler zu korrigieren, welche zusätzlich an einer weiteren Kristallseite Licht detektieren. Besonders für SiPMs vom Stand der Technik erhöhen sich die Kosten dadurch immens. Ein Konzept für DOI-Detektion, welches nur an einer Kristallseite Licht detektiert und dabei monolithische Kristalle verwendet, ist in [5] publiziert und in [6] patentiert. Es verwendet das bekannte Prinzip, dass die Lichtverteilung des Kristalls abhängig von der DOI ist. Das verwendete Detektorkonzept ist mit monolithischen Kristallen an positionssensitive Photomultiplier (PMT) H8500 von Hamamatsu gekoppelt. Außerdem wird ein Widerstandsnetzwerk verwendet, welches Positionskodierung und damit auch Ausgangskanalreduzierung ermöglicht. Dabei wird die Standardabweichung der Lichtverteilung verwendet, um die DOI abzuschätzen. Zur Berechnung der Standardabweichung benötigt man das Moment der 1. und 2. Ordnung der Lichtverteilung. Das Moment 1. Ordnung ist bereits durch die Linearkodierung der Ausgangskanäle gegeben. Zur Bestimmung des Moments 2. Ordnung ist ein Summennetzwerk entwickelt worden und in das Widerstandsnetzwerk integriert

Einen Überblick von PET-Detektoren mit DOI-Detektion ist in [7] zusammengefasst. Beschreibungen und Ergebnisse von Kleintier-PET- und MR/PET-Hybridscannern, welche in den letzten Jahren entwickelt worden sind, befinden sich in [8-11].

Detektorkonzepte, welche auf aktueller SiPM-basierter Technologie bestehen und eine Positionskodierung zur Kanalreduktion enthalten, beinhalten keine DOI-Detektion. Deswegen beinhalten PET-Ringe, die mit diesen Detektoren aufgebaut sind, Parallaxe Fehler in der Rekonstruktion. Darüber hinaus verwenden die meisten pixilierte Kristallarrays. Dieses führt wie oben beschrieben zu einem Verlust an Sensitivität bedingt durch die Reflektorfolie und dem Kleber zwischen den Kristallen des Arrays. Aufgrund der fehlenden DOI-Information ist man bei der Dicke der Kristalle begrenzt. Eine Erhöhung der Sensitivität durch dickere Kristalle kommt einher mit einem Verlust an Ortsauflösung bedingt durch fehlende DOI-Information. Die in [7] genannten DOI-Konzepte für pixilierte Kristalle können nicht mit beliebig kleinen Kristallen verwendet werden und funktionieren nicht für Kristallarrays mit 0.8 mm oder 0.5 mm Kristallgrößen. Das Hauptproblem bei fehlender DOI-Detektion ist, dass die PET-Ringgröße limitiert ist und ein schmalerer Ring die Ortsauflösung verringern würde.

Der in [4] beschriebene Detektor ist mit monolithischen Kristallen realisiert. Es wurde ein eng anliegender Ring entworfen, um die Sensitivität zu erhöhen. Gleichzeitig wurden monolithische Kristalle verwendet. Aufgrund der resultierenden kurzen Distanz zwischen den Szintillationskristallen und dem Untersuchungsobjekt, ist das DOI Problem erhöht. Deswegen sind die Entwickler des Ringes auf 2 mm Kristalldicke eingeschränkt. Dies hat zur Folge, dass die gewonne Sensitivität durch den schmalen Ring und die Verwendung von monolithischen Kristallen durch die kurze Dicke der Szintillationskristalle wieder verloren geht. Allerdings beweist diese Arbeit, dass eine hohe Auflösung mit monolithischen Kristallen möglich ist.

DOI-Positionen mit SiPM-basierten Detektoren können bestimmt werden, indem an zwei Kristallflächen Sensoren angebracht werden. Diese benötigt die doppelte SiPM-Sensorfläche. Aktuell sind SiPM-Sensoren eine der teuersten Komponenten eines PET-Rings.

Methoden die DOI-Informationen messen, sind derzeit noch nicht mit SiPMs an nur einer Kristallseite eines monolithischen Kristalls realisiert. Das Konzept, welches in [5, 6] realisiert ist, verwendet positionssensitive PMT, welche nicht in starken magnetischen Feldern verwendet werden können. Dadurch sind sie nicht MRT-kompatibel. Das Konzept könnte mit MRT-kompatiblen Avalanche Photodioden (APD) realisiert werden, was bis heute noch nicht geschehen ist. APDs sind Photodioden, welche einen Avalanche-Effekt erfahren, wo durch Licht generierte Photoelektronen beschleunigt werden und mehr Elektronen aktivieren. Der resultierende Photostrom hängt von der Lichtintensität ab, wie es bei PMTs der Fall ist. Trotzdem ist eine Realisierung dieses Konzeptes auf SiPM-Mikrozellenebene eine andere Herausforderung, da SiPM-Mikrozellen binäre Sensoren sind und in einem anderen Modus, dem sogenannten Geiger-Modus betrieben werden.

Ein dreidimensionaler Tier-PET-Scanner wurde von Judenhofer et. al. [8] in einem 7T Tierscanner integriert. Er basiert auf APDs welche Szintillationskristalle mit einer Dicke von 4.5 mm verwenden und aus Kristallarrays mit 144 Kristallen bestehen, welche einen Abstand von 1.6 mm haben. Das Kristallarray ist an ein 3-mal-3 großes APD-Array gekoppelt. Das axiale Bildfeld (FOV) beträgt 19 mm. Dieses entwickelte System zeigt, dass spezielle für integrierte Systeme der Platz stark limitiert ist, welches einen Kompromiss zwischen Kristalldicke und axialem FOV erzwingt. Dies resultiert in der niedrigen Sensitivität von 0.23 % des Systems. Darüber hinaus limitiert auch hier das DOI-Problem die Kristalldicke.

Ein weiterer Prototypenscanner, der unter dem Namen MADPET veröffentlicht wurde, ist in seiner ersten Version in München entwickelt worden [9]. Er ist mit APDs, welche direkt an 3.7 mm x 3.7 mm x 12 mm Kristalle gekoppelt wurden, realisiert. Dieser Prototypenscanner zeigt das Problem einer Erhöhung der Auslesekanäle bei Verwendung von 1-zu-1 Kopplung. Im ersten Scanner ist es nicht möglich alle Kanäle gleichzeitig auszulesen. Außerdem ist eine geringe Sensitivität ein Problem des Scanners. In einer zweiten Version des Scanners, MADPET II, wurde dieses Problem gelöst und die Auslesung aller APDs ist möglich [14]. Die zweite Version verfügt auch über ein zweilagiges Auslesesystem, mit zwei Schichten von Kristallen mit dazwischenliegenden APDs. Da die Kristalle demzufolge aufgeteilt sind, lassen sich auch DOI-Positionen bestimmen. Es wird allerdings auch die doppelte Menge an Sensorflächen benötigt und damit werden die Auslesekanäle erneut erhöht. Außerdem entstehen durch die ungefähr doppelte Sensormenge höhere Kosten.

Die Möglichkeit von DOI-Detektion mit positionssensitiven PMTs ist in [10, 11] bewiesen worden.

Forschungsergebnisse mit Detektoren bestehend aus SiPMs und monolithischen Kristallen sind in [12] publiziert. In diesem Ansatz werden SiPMs auf der gleichen Art und Weise benutzt, wie das ursprüngliche Konzept für PMTs und APDs in [5, 6] publiziert wurde.

Die Veröffentlichung "Characterization of Linearly Graded Position-Sensitive Silicon Photomultipliers" von Alessandro Ferri et al. in der Zeitschrift IEEE TRANSACTIONS ON NUCLEAR SCIENCE, Vol. 62 NO. 3, June 2015 offenbart einen SiPM-Sensorchip mit einer Vielzahl von Pixeln, die kein Summiernetzwerk besitzt.

Die EP 2 495 585 A2 offenbart eine technische Lösung zur Auslesung von Signalen pixelierter Sensoren von Gammastrahlungsdetektoren bei der die Anzahl von notwendigen Auslesekanälen gegenüber dem Stand der Technik reduziert ist.

In der WO 2015/063704 A1 wird ein Photomultiplier mit einer hohen räumlichen Auflösung in xy-Richtung offenbart-

Es ist die Aufgabe der Erfindung einen Sensorchip zur Verfügung zu stellen, der die Nachteile des Standes der Technik überwindet mit dem der Parallaxenfehler bei der Bestimmung einer LOR verringert werden kann. Es soll ein Sensorchip zur Verfügung gestellt werden, der die Verwendung von Szintillations-Einkristallen für die Detektion von Signalen bei der Positronen-Emissions-Tomographie ermöglicht, wobei das DOI-Problem vermieden werden kann, indem der Parallaxenfehler bei der Bestimmung der LOR verringert wird.

Die Empfindlichkeit und die Auflösung des Sensorchips sollen verbessert werden. Weiterhin soll der Sensorchip geeignet sein zusammen mit einem MRT insbesondere bei hohen Magnetfeldern betrieben zu werden. Die Genauigkeit von klein dimensionierten PET-Ringen bzw. bei PET-Ringen, die eng am Untersuchungsobjekt anliegen, soll verbessert werden. Der Platzbedarf durch die der Messanordnung zugehörige Elektronik soll verringert werden. Die Kosten für die Vorrichtung sollen verringert werden. Der Sensorchip soll in seiner Anwendung nicht auf die Verwendung in der PET beschränkt sein, sondern soll generell für Szintillations-Einkristalle verwendet werden können.

Ausgehend von dem Oberbegriff des Anspruchs 1 wird die Aufgabe erfindungsgemäß gelöst mit den im kennzeichnenden Teil des Anspruchs 1 angegebenen Merkmalen.

Die eingangs genannten Aufgaben werden gelöst.

Mit dem erfindungsgemäßen Sensorchip ist es nunmehr möglich, Parallaxenfehler bei der Bestimmung der LOR's, insbesondere bei Szintillations-Einkristallen, zu verringern. Die Empfindlichkeit und die Auflösung der Messmethode und der Vorrichtung werden verbessert. Der Einsatz von in z-Richtung längeren Szintillations-Einkristallen soll ermöglicht werden. Der Detektor kann zusammen mit einem MRT-Gerät betrieben werden. Insbesondere bei Geräten mit kleiner Dimensionierung oder wenn der PET-Ring eng am Untersuchungsobjekt anliegt wird der Parallaxenfehler verringert. Es wird Platz für die zugehörige Elektronik und Kosten eingespart. Der erfindungsgemäße Sensorchip erreicht eine sehr hohe Detailgenauigkeit. Denn die Anzahl der Abtastungen der Lichtverteilungsfunktion wird dadurch signifikant erhöht, da sogar eine Abtastung auf Mikrozellebene möglich ist. Dadurch erhöht sich die Granularität um einen Faktor, der Abhängig von den später beschriebenen Implementierungsmethoden bis zu 160 oder höher gegenüber herkömmlichen SiPM's, Photomultipliern bzw. Avalanche-Dioden betragen kann. Dies führt zu einer genaueren Bestimmung des Moments 2.Ordnung führt.

Im Folgenden wird die Erfindung in ihrer allgemeinen Form beschrieben, ohne dass dies einschränkend auszulegen ist.

Es wird ein Detektorkonzept für PET-Messungen zur Verfügung gestellt, bei dem jeder einzelne Detektor einen Szintillations-Einkristall und mindestens einen Sensorchip aufweist, der an einer Seite des Szintillationskristalls positioniert ist. Vorzugsweise ist der Sensorchip auf der xy-Ebene des Szintiallations-Einkristalls angebracht, besonders bevorzugt auf der Seite des Szintillations-Einkristalls, die dem Zentrum des Detektorrings abgewandt ist. In einer anderen Ausführungsform kann der Sensorchip an einer Seite des Szintillations-Einkristalls angebracht sein, die sich nicht auf der xy-Ebene befindet, beispielsweise auf der xz- oder yz-ebene. Das hat jedoch den Nachteil, dass für Sensorchips, die auf der xz- oder yz-Ebene angebracht sind, Scannersensitivitätsverluste entstehen. Befindet sich der Sensor auf der dem Zentrum zugewandten Seite, entstehen zusätzliche Compton-Effekte.

Es können auch mehrere Szintillations-Einkristalle an einen Sensorchip gekoppelt werden.

Die Verwendung des Szintillations-Einkristalls hat den Vorteil, dass die Sensitivität des Einkristalls gegenüber gepixelten Szintillationskristallen maximiert werden kann. Bei gepixelten Szintillationskristallen wird die Effizienz der Szintillationseinkristalle erheblich reduziert, beispielsweise auf nur 71 % oder 59 % bei 0,8mm x 0,8mm oder 0,5mm x 0,5 mm Kristallpixelgröße eines gepixelten Kristallarrays.

Der Szintillations-Einkristall kann beispielsweise aber nicht beschränkend aus LSO, LYSO, BGO, GSO, BaF₂ oder Nal:TI (Thallium dotiertes Natriumjodid) bestehen. Die Materialien sind dem Fachmann bekannt.

Das Verhältnis der z-Komponente des Szintillations-Einkristalls zu dessen Ausdehnung in x-Richtung von kleiner oder gleich 1 führt zu guten Ergebnissen bei quadratischem Querschnitt für xy. Die besten Ergebnisse erhält man bei einem Verhältnis von 0,25. Gegebenenfalls kann das Verhältnis auch kleiner sein. Die dabei erreichte Länge des Szintillations-Einkristalls ist eher durch praktische Umstände bestimmt, wie beispielsweise den Durchmesser des PET-Ringes oder die Kosten, die mit großen Einkristallen verbunden sind. Die Dimensionierung des Szintillations-Einkristalls in z-Richtung hängt von der gewünschten Sensitivität ab, die erreicht werden soll. Das Erreichen der großen Ausdehnung des Szintillations-Einkristalls in z-Richtung ist ein Resultat der im folgenden beschriebenen erfindungsgemäßen Ausgestaltung des Sensorchips, welcher eine solche Dimensionierung ermöglicht, bei der es zu einer Minimierung von DOI-Fehlern kommt.

Der Sensorchip ist erfindungsgemäß ein SiPM und besteht aus SiPM-Mikrozellen.

An einem Szintillations-Einkristall können ein Sensorchip oder mehrere kleine Sensorchips aufgebracht sein, die zu einem größeren Sensorchip zusammengesetzt werden.

Diese können auf den Szintillations-Einkristall aufgeklebt werden. Für den Fall, dass mehrere kleine Sensorchips zusammengefasst werden, gelten diese als ein einziger Sensorchip im Sinne der Erfindung, wenn sie auf nur einer Seite des Szintillations-Einkristalls angebracht sind. Der dazu verwendete Klebstoff soll lichtdurchlässig sein. Weiterhin kann sich zwischen dem Szintillations-Einkristall und dem Sensorchip eine Schicht eines Lichtverteilers befinden, falls die Lichtintensität zu gebündelt ist.

Es ist auch eine Anordnung möglich, bei der mehr als ein Sensorchip an dem Einkristall angebracht ist. Beispielsweise kann eine Stapelung entlang der z-Achse vorliegen, bei der sich Sensorchips und Szintillationseinkristalle abwechseln. Dies ist insbesondere dann sinnvoll, wenn Szintillations-Einkristalle verwendet werden, in denen sich die Lichtverteilung in bestimmten Kristallbereichen nicht so stark unterscheiden lässt, und eine Aufteilung des Szintillations-Einkristalls in mehrere Schichten mit jeweils einem Sensor sinnvoll ist.

In einer anderen Ausführungsform können auch Sensorchips an den Seiten des Szintillations-Einkristalls angebracht sein, die nicht auf der xy-Ebene des Szintillations-Einkristalls liegen. Es können ein, zwei oder mehrere, beispielsweise 3 Sensorchips auf verschiedenen Seiten angebracht sein. Dabei können Sensorchips auf zwei gegenüberliegenden Seiten des Szintillations-Einkristalls oder auf angrenzenden Seiten des Szintillations-Einkristalls angebracht sein, die in xz- oder yz- Richtung liegen. Es ist jede Unterkombination denkbar. Die Variante, bei der Sensorchips auf gegenüberliegenden Seiten angebracht sind, hat den Vorteil, dass damit die Genauigkeit gesteigert wird, wenn ein Messsignal empfangen wird. Gemäß der erfindungsgemäßen Ausgestaltung des Verfahrens und der Vorrichtung besteht jedoch gerade der Vorteil, dass die Signale lediglich an einer Seite des Szintillations-Einkristalls ausgelesen werden müssen. Das entspricht einer Ausführungsform mit einem einzigen Sensorchip. Damit werden das erfindungsgemäße Verfahren und die Vorrichtung auch kostengünstig.

Der Sensorchip besteht erfindungsgemäß aus einer Vielzahl von Pixeln, die sich dadurch auszeichnen, dass jedem Pixel eine eigene xy-Position zugeordnet wird. Ein Pixel besteht aus mindestens einer Photodiode, Quenchwiderständen und einem Stromteiler der den generierten Photostrom der Dioden in zwei gleich große Anteile teilt.

Anstelle eines Quenchwiderstandes kann der Quenchprozess auch durch aktives Quenchen, mit den dem Fachmann bekannten Methoden, z. B. unter Verwendung eines Transitors, eingeleitet werden. In der folgenden Beschreibung wird in den offenbarten Ausführungsformen ein Quenchwiderstand Rq offenbart. Jedoch kann bei allen Ausführungsformen auch ein anderes äquivalentes Mittel zum Quenchen, beispielsweise ein Transistor eingesetzt werden, so dass die Offenbarung nicht auf die Verwendung eines Quenchwiderstandes beschränkt ist.

Die Pixel sind in einem Raster angeordnet, bei dem die Pixel in Reihen in x-Richtung und in y-Richtung angeordnet sind. Dabei sind die Pixel in Reihen bzw. Spalten vorzugsweise parallel zur der x- Achse und der y-Achse angeordnet. Typischerweise sind 10, 100 oder 1000 Pixel in jeweils der x-Richtung und der y-Richtung angeordnet. Die Anordnung enthält dann N Reihen in x-Richtung xₙ = x₁, x₂, x₃, ....x_{N} mit n = 1, 2, ...N und M Reihen in Y-Richtung yₘ = y₁, y₂, y₃.... y_{M} mit m = 1, 2, ....M. Die Richtungen x und y sind vorzugsweise orthogonal zueinander angeordnet, sie können jedoch auch in einem Winkel angeordnet sein, der von 90° abweicht, so dass ein Rautenmuster entsteht.

Diese Anordnung bildet einen Block. Ein Sensorchip kann eine Mehrzahl von Blöcken aufweisen, die in einem Raster angeordnet sind.

In einer ersten Ausführungsform besteht ein Pixel aus einer einzigen SiMP-Mikrozelle, die aus einer Photodiode mit 2 Quenchwiderständen besteht, die zusammen einen Stromteiler bilden. Der Begriff SiMP-Mikrozelle wird im Folgenden als Mikrozelle bezeichnet.

Diese Anordnung führt zu einer sehr hohen Detailgenauigkeit. Durch die Anordnung von 100x100 oder 1000x1000 Mikrozellen in einem einzelnen SiPM wird bei der Integration in den Mikrozellenbereich das Moment 2. Ordnung aus 100 oder 200 bzw. 1000 bis 2000 Abtastpunkten der Lichtverteilung bestimmt. Typische PS-PMTs oder Arrays von SiPMs haben eine Detailgenauigkeit von 10 bis 20 in jede Ortsrichtung. Mit dem neuen Sensorchip wird die Anzahl der Abtastungen der Lichtverteilungsfunktion um einen Faktor von 5 oder mehr gegenüber nicht Chip-implementierten SiPM's oder Photomultipliern bzw. Avalanche-Dioden erhöht, was zu einer besseren Bestimmung des Moments zweiter Ordnung mit den erfindungsgemäßen Sensorchips führt, da jede Mikrozelle über eine individuelle Positionskodierung verfügt und zu einem Signal führt, welches der Auswertung zugeführt wird.

Die Position einer Mikrozelle in diesem Raster ist dann auf der xy-Ebene durch xₙyₘ gekennzeichnet, da jeder Pixel nur eine Mikrozelle enthält.

In jeder dieser Positionen befindet sich eine Mikrozelle, bestehend aus der Photodiode Dₙₘ, die ein Ausgangsnetz N_{D,n m} hat, dem ein Stromteiler S_{q,nm} nachgeschaltet ist, der zwei Quenchwiderstände R_{q,nm,h} und R_{q,nm,v} aufweist, bei denen der Index v die y-Richtung und der Index h die x-Richtung bezeichnet und wobei die Photodiode an einer Versorgungsspannung V_{ref} angeschlossen sind. Die Quenchwiderstände sind gleich groß und liegen in einem Bereich von 1 Megaohm und 100 Megaohm. Die Referenzspannung V_{ref} kann in Abhängigkeit von der Herstellungstechnologie zwischen -20 Volt und -40 Volt liegen. In den Bezeichnungen Dₙₘ, R_{q,nm,h} oder R_{q,nm,v} geben n die Position der Photodioden und der Quenchwiderstände entlang der x-Achse und m die Position entlang der y-Achse an. N_{D,nm} bezeichnet die Verbindungsleitungen der Photodiode mit dem Stromteiler S_{q,nm}, der der Photodiode nachgeschaltet ist.

Die an den Quenchwiderständen R_{q,nm,h,} und R_{q,nm,v,} angeschlossenen Netze N_{S,v,m} und N_{S,h,n} bei denen der Index v die y-Richtung und der Index h wiederum die die x-Richtung bezeichnen, münden in weitere Stromteiler S_{h,n} und S_{v,m}, welche die Kodierwiderstände R_{h,A,n} und R_{h,B,n} bzw. R_{v,C,m} und R_{v,D,m} aufweisen, die in die Ausgangskanäle A, B, C und D führen. Entsprechend den fortlaufenden Koordinaten xₙyₘ für eine Reihe in x-Richtung und eine Reihe in y-Richtung weisen die Kodierwiderstände für jeweils eine Koordinate xy R_{h,A,n} und R_{h,B,n} bzw. R_{v,C,m} und R_{v,D,m} verschiedene Kodierwiderstandswerte auf, die für jeweils eine Reihe x oder eine Reihe y eine Positionskodierung bezüglich die xy-Koordinaten ermöglicht. So können die Kodierwiderstände R_{h,A,n} und R_{h,B,n} bzw. R_{v,C,m} und R_{v,D,m} beispielsweise Innerhalb einer x-Reihe mit fortschreitenden Positionen xₙy₁, xₙy₂, xₙy₃...xₙy_{M}, und innerhalb einer y-Reihe mit fortschreitenden Positionen x₁yₘ, x₂yₘ ...xₙyₘ für die Einmündungen in die Ausgangskanäle A und B bzw. C und D fortlaufende Werte annehmen, was die Positionskodierung ermöglicht. Die Kodierwiderstände haben Widerstandswerte, die üblicherweise in der Größenordnung zwischen 10Ω und 1kΩ liegen. Die genaue Position des detektierten Lichtes wird durch die aktiven Mikrozellen gegeben. Die aktiven Mikrozellen mit den Koordinaten xy können mittels der Formel (A-B)/(A+B) bzw. (C-B)/(C+B) ermittelt werden. Das Prinzip ist als Anger-Logik bekannt.

Für die Positionskodierung werden die Kodierwiderstandswerte linear kodiert, wobei sich die Kodierwiderstände, welche die x-Richtung kodieren, an Ausgangskanal A und B angeschlossen sind, in auf- und absteigender Weise entgegengesetzt linear ändern. Das bedeutet, Kanal A kann linear aufsteigend und Kanal B linear absteigend kodiert werden oder umgekehrt. Gleiches gilt für die y-Richtung, welche mit Kanal C und D kodiert werden. Als Resultat wird der generierte Photostrom einer jeden Mikrozelle abhängig von der Position individuell auf die Auslesekanäle aufgeteilt.

Die Kodierwiderstandswerte R_{h,A,1} und R_{h,B,n}, R_{h,A,2} und R_{h,B,n-1}, R_{h,A,3} und R_{h,B,n-2} ... R_{h,A,n} und R_{h,B,1}, sowie R_{v,C,1} und R_{v,D,n}, R_{v,C,2} und R_{v,D,n-1}, R_{v,C,3} und R_{v,D,n-2}... R_{v,C,n} und R_{v,D,1}, bestimmen nicht nur die für die Positionskodierung wichtige Photostromverteilung, sondern werden erfindungsgemäß gleichzeitig so gewählt, dass sich die für das unten beschriebene Summiernetzwerk erforderliche Spannung einstellt, die für die Berechnung der Tiefeninformation für die Position der Szintillation benötigt wird. Die Kodierwiderstände sollen möglichst präzise in den Chip implementiert werden, um eine möglichst genaue lineare Kodierung zu erhalten.

In einer zweiten Ausführungsform besteht ein Pixel aus mindestens einer Photodiode D_{nm,k} mit jeweils einem eigenen Quenchwiderstand R_{q,nm,k} mit k = 1, 2, 3, ... K und einem Stromteiler S_{nm,} bestehend aus den Widerständen R_{nm,v} und R_{nm,h}. Die Widerstände R_{nm,v} und R_{nm,h} sind gleich groß und liegen der Größenordnung vom 1kΩ bis 100 kΩ. Hierbei liegt K typischerweise im Bereich von 1 bis 100. Eine Mikrozelle besteht in dieser Ausführungsform aus einer Photodiode D_{nm,k} mit jeweils einem eigenen Quenchwiderstand R_{q,nm,k}. Die Quenchwiderstände R_{q,nm,k} sind alle gleich groß und liegen in der Größenordnung von 1 Megaohm bis 100 Megaohm. Der generierte Photostrom der Photodioden D_{nm,k} wird über die Quenchwiderstände R_{q,nm,k} und das Netz N_{l,nm} zusammengeführt. Der gesamte generierte Photostrom des so entstehenden Clusters von Mikrozellen, jeweils bestehend aus den Photodioden D_{nm,k} und den Quenchwiderständen R_{q,nm,k}, wird in einen gemeinsamen Stromteiler Sₙₘ geführt. Der Stromteiler Sₙₘ teilt den Gesamtstrom in einen gleichen Anteil zur x- und y-Kodierung auf, der wie oben beschrieben über weitere Stromteiler S_{h,n} bzw. S_{v,m} in die Ausgangskanäle A und B bzw. C und D führt.

Beispielsweise können in diesem Cluster in jede Richtung x und y 10 Mikrozellen zusammengefasst werden. Der Wert ist nicht einschränkend auszulegen, vielmehr können auch 20, 50 oder 100 Mikrozellen zusammengefasst werden, je nachdem, was die Prozesstechnik zulässt. So können Signale aus mindestens zwei Mikrozellen aus einer x-Richtung oder einer y-Richtung als ein einziges zusammengefasstes Signal weitergeleitet werden. Diese Ausführungsform hat den Vorteil, dass ein starker Photostrom pro Pixel erhalten werden kann. Jedoch ist die erste Ausführungsform bevorzugt, um eine maximale Auflösung bzw. Granularität zu erhalten. Beide Ausführungsformen für die Pixel können in einem Sensorchip verwirklicht sein.

Für jede Pixelreihe x und/oder y der beiden Ausführungsformen werden die Potentiale an den Netzen N_{S,h,1}, N_{S,h,2}... N_{S,h,N} bzw. N_{S,v,1}, N_{S,v,2}... N_{S,v,M} über die Summiererwiderstände R_{S,h,n} bzw. R_{S,v,m}, abgegriffen und in ein Summiernetzwerk mit den Ausgangskanälen E und F geführt. Dabei sind Ausführungsformen möglich, bei denen entweder die Netze N_{S,h,1}, N_{S,h,2}, ... N_{S,h,N} für die x-Richtung oder die Netze N_{S,v,1}, N_{S,v,2}, ... N_{S,v,M} für die y-Richtung an ein Summiernetzwerk Oₕ bzw. Oᵥ angeschlossen sind oder vorzugsweise die Netze N_{S,h,1}, für die x-Richtung und N_{S,v,m}, für die y-Richtung in Summiernetzwerke Oₕ bzw. Oᵥ mit den Ausgangskanälen E und F angeschlossen sind. Die Widerstandswerte für die Summiererwiderstände R_{S,h,n} bzw. R_{S,v,m} sind jeweils in einem Summierernetzwerk Oₕ bzw. Oᵥ gleich groß. Die Summiererwiderstandswerte können zwischen 1 kΩ bis 100 kΩ liegen. Die Summiererwiderstände R_{S,h,n} bzw. R_{S,v,m} müssen dabei so groß sein, dass der generierte Photostrom von den SiPM-Dioden nicht wesentlich beeinflusst wird, jedoch klein genug, um nicht das Quenchverhalten der Mikrozellen zu beeinflussen. Die Summiererwiderstände R_{S,h,n} bzw. R_{S,v,m} sind über das Netz N_{S,h} bzw. N_{S,v} zusammengeführt. Somit werden die Signale aufsummiert.

Die Summiernetzwerke Oₕ und/oder Oᵥ können einen Operationsverstärker OPₕ bzw. OPᵥ, beinhalten, der geerdet ist und eine negative Rückkopplung mit einem Widerstand R_{S,h} bzw. R_{S,v} besitzt. Über das Verhältnis von R_{S,h}/R_{S,h,n} bzw. R_{S,v}/R_{S,v,m} kann die Verstärkung des Signals der Ausgangskanäle E und F eingestellt werden. Die Summiernetzwerke Oₕ und/oder Oᵥ können in den Sensorchip intergiert sein oder es können sich jeweils Teile davon weniger bevorzugt außerhalb des Sensorchips befinden.

Befindet sich das gesamte Summierernetzwerk Oₕ bzw. Oᵥ außerhalb des Sensorchips, so hat dies zur Folge, dass alle Netze N_{S,h,n} und/oder N_{S,v,m} aus dem Sensorchip herausgeführt werden, was zu einer sehr hohen Anzahl von Ausgangskanälen führt. Sind die Summiererwiderstände R_{S,h,n} und/oder R_{S,v,m} in dem Sensorchip integriert, müssen nur die Netze N_{S,h} und/oder N_{S,v} aus dem Sensorchip herausgeführt werden, was mit einem Ausganskanal realisiert werden kann.

Es ist jedoch aus Gründen der Platzersparnis und zur Reduzierung von Rauscheinflüssen bevorzugt, das komplette Summierernetzwerk Oₕ bzw. Oᵥ in den Chip zu integrieren.

Die Potentiale an den Netzen N_{S,h,n} und N_{S,v,m} sollten jeweils möglichst genau quadratisch verteilt werden. Dies ist erforderlich um das Moment 2. Ordnung zu erhalten. Es gibt dabei die Möglichkeit über Spannungsteiler unter Einbringung von weiteren Widerständen eine quadratische Spannungskodierung der Netze zu ermöglichen, ohne dass diese zusätzlichen Widerstände die Photostromverteilung verändern. Um eine möglichst platzsparende Chipintegration zu erhalten, empfiehlt es sich keine zusätzlichen Widerstände zu verwenden, sondern die Kodierwiderstände ebenfalls zur Spanungseinstellung zu wählen. Die Widerstände des Stromteilers S_{q,nm} in der ersten Ausführungsform bzw. Sₙₘ in der zweiten Ausführungsform bilden zusammen mit den Kodierungswiderständen R_{h,A,1} und R_{h,B,1} ... R_{h,A,N} und R_{h,B,N} bzw. R_{v,C,1} und R_{v,D,1} ... R_{v,C,M} und R_{v,D,M} einen Spannungsteiler. Da die Kodierungswiderstände R_{h,A,n} und R_{h,B,n} bzw. R_{v,C,m} und R_{v,D,m} einen Stromteiler darstellen berechnet sich der Gesamtwiderstand eines Stromteilers gemäß der Formel (R_{h,A,n} * R_{h,B,n}) / (R_{h,A,n} + R_{h,B,n} bzw. (R_{v,C,m} * R_{v,D,m}) / (R_{v,C,m} + R_{V,D,m}). Wählt man die Kodierwiderstände, welche sich üblicherweise in der Größenordnung von 10Ω bis 1kΩ befinden linear entgegengesetzt an- und absteigen für Ausgangskanal A und B bzw. C und D aus, stellt sich ein quadratischer Gesamtwiderstandswert des Stromteilers S_{h,n} bzw. S_{v,m} und damit die benötigte quadratisch verlaufende Potentialverteilung in den Netzwerken N_{S,v,m} und/oder N_{S,h,n} automatisch ein. Gleichzeitig ist die lineare Kodierung für den Photostrom gegeben. Wichtig ist hierbei, dass die Kodierwiderstände der jeweiligen zwei Auslesekanäle linear an- und absteigen und die Maximal- und Minimalwerte, also die Start und Endwerte des linearen Verlaufs einer jeden Richtung gleich gewählt sind. Mathematisch ausgedrückt muss gelten R_{h,A,n} = Rₘᵢₙ + (n-1) * R_{Schritt}, R_{h,B,n} = Rₘₐₓ - (n-1) * R_{Schritt}, R_{h,A,N} = Rₘₐₓ und R_{h,B,N} = Rₘᵢₙ bzw. R_{v,C,m} = Rₘᵢₙ + (m-1) * R_{Schritt}, R_{v,D,m} = Rₘₐₓ - (m-1) * R_{Schritt}, R_{v,C,M} = Rₘₐₓ und R_{v,D,M} = Rₘᵢₙ.

Die Potentiale Φ(N_{S,h,n}) bzw. Φ (N_{S,v,m}) an den Netzen N_{S,h,n} und N_{S,v,m} können durch entsprechende zusätzliche Widerstände oder durch modifizierte Kodierwiderstände auch von einer exakten quadratischen Kodierung abweichen. Hierbei muss für die resultierende Potentialkodierung (Φ²ⁿ)^{k} mit n= 1, 2, 3... und 0,5 < k < 1,5 gelten.

Die dargestellten Funktionen sind in den Sensorchip erfindungsgemäß mindestens teilweise jedoch vorzugsweise vollständig integriert. Dazu können dem Fachmann bekannt Halbleiterprozesstechniken, wie beispielsweise das C-MOS Verfahren oder spezielle SiPM-Herstellungsverfahren, wie RGB-SiPM, RSB-HD-SiMP oder NUV-SiMP angewendet werden. Insbesondere die Integration des Summiernetzwerkes Oᵥ bzw. Oₕ in den Sensorchip hat den Vorteil, dass neben der Platzersparnis, Signalstörungen minimiert werden und das Signal-zu-Rauschverhältnis optimiert wird.

Die erfindungsgemäßen Sensorchips können zu einem Block a x b in einem Raster angeordnet sein. Hierbei erstrecken sich die linearen Positionskodierungen sowie quadratische Kodierung der Potentiale sensorübergreifend über mehrere Sensorchips in die Richtungen a und b.

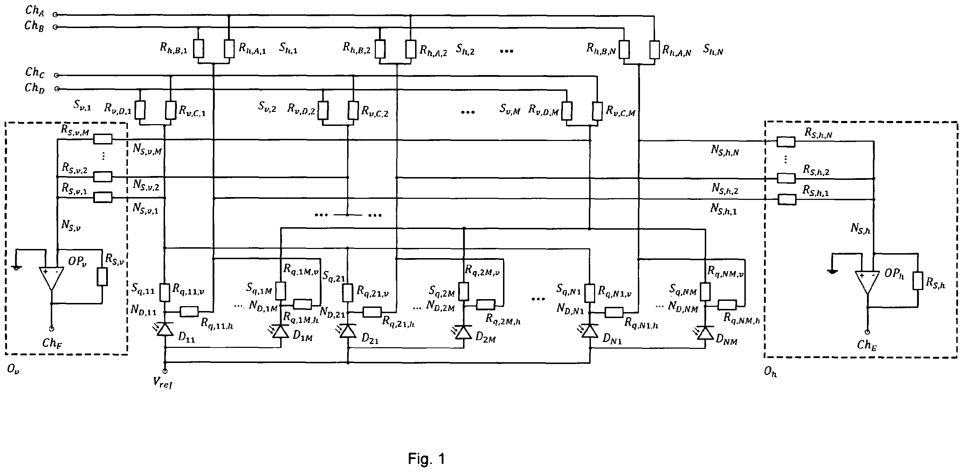

Genauso ist es möglich, einen einzelnen Sensorchip in J Blöcke beliebiger xy-Größe zu unterteilen, mit j = 1,... J. Hierbei erstreckt sich die Positionskodierung, Potentialkodierung und das Summiernetzwerk jeweils nur über einen einzelnen Block des Sensorchips. Ein Block ist dabei genauso aufgebaut wie ein Sensorchip, der in Figur 1 dargestellt ist. Der Sensorchip beinhaltet in der Ausführungsform mit J Blöcken Ausgangskanäle Aⱼ, Bⱼ, Cⱼ und Dⱼ sowie Eⱼ und/oder Fⱼ für jeden Block j. Diese Ausführungsform hat den Vorteil, dass sich mehrere Blöcke in einen Sensorchip integrieren lassen können, ohne dass es zu nichtphotosensitiven Zwischenräumen zwischen den Blöcken kommt.

Im Folgenden wird die Erfindung an Hand der Figuren erläutert, was jedoch nicht einschränkend auszulegen ist.

Es zeigt:
- Fig. 1:: Ein Sensorchip in der ersten Ausführungsform
- Fig. 2:: Ein Pixel des Sensors in der 2. Ausführungsform
- Fig. 3:: Eine Darstellung der Lichtverteilung in Abhängigkeit von der Interaktionstiefe im Einkristall
- Fig. 4:: Ausgangssignale der positionskodierten Kanäle
- Fig. 5:: Ausgangsspannung des Summiernetzwerks
- Fig. 6:: Ausgangssignal des Summierernetzwerks in Abhängigkeit von der Interaktionstiefe.

In Figur 1 sind die Bestandteile des erfindungsgemäßen Sensorchips dargestellt. Es werden Photodioden D₁₁ ... D_{1M}, D₂₁ ... D_{2M} ... D_{N1}... D_{NM} dargestellt, die an eine Referenzspannung V_{ref} angeschlossen sind. Von den Photodioden D₁₁ ... D_{1M}, D₂₁ ... D_{2M} ... D_{N1} ... D_{NM} zweigen über Ausgangsnetze N_{D,nm} Stromteiler S_{q,nm} mit Quenchwiderständen R_{q,11,h} und R_{q,11,v} ... R_{q,1M,h} und R_{q,1M,v,} R_{q,21,h} und R_{q,21,v} ... R_{q,2M,h} Und R_{q},_{2M,v,} R_{q,N1,h} und R_{q,N1,v} ... R_{q,NM,h} und R_{q},_{NM,v} ab, die über die Netze N_{S,h,1} ... N_{S,h,N} bzw. N_{S,v,1} ... N_{S,v,M} an weitere Stromteiler S_{h,nm} bzw. S_{v,nm} mit den Kodierungswiderständen R_{h,A,1} und R_{h,B,1} ... R_{h,A,N} und R_{h,B,N}, die in die Ausgangskanäle A und B münden und Stromteiler mit den Kodierungswiderständen R_{v,C,1} und R_{v,D,1} ... R_{v,C,M} und R_{v,D,M}, die in die Ausgangskanäle C und D münden, angeschlossen sind. Die Netze N_{S,h,1} ... N_{S,h,N} bzw. N_{S,v,1} ... N_{S,v,M} sind an Summiererwiderstände R_{S,h,1} ... R_{S,h,N} bzw. R_{S,v,1} ... R_{S,v,M} an einen bzw. zwei geerdete Operationsverstärker OPₕ und OPᵥ, die Ausgangskanäle E und F besitzen, angeschlossen. Die Operationsverstärker OPₕ und OPᵥ sind über Operationsverstärkerwiderstände R_{S,h} und R_{S,v} negativ rückgekoppelt. Weiterhin ist in Figur 1 angedeutet, dass durch Punkte angedeutete weitere Photodioden und Stromteiler mit Quenchwiderständen in einem Raster auf den Sensorchip angeordnet sind und in weitere Netze N_{S,h,2} und N_{S,v,2}, N_{S,h,3} und N_{S,v,3} usw. in die Summiernetzwerke Oₕ und Oᵥ geführt werden.

Die Quenchwiderstände R_{q,nm,h} bzw. R_{q,nm,v} bilden zusammen mit den Kodierungswiderständen R_{h,A,1} und R_{h,B,1} ... R_{h,A,N} und R_{h,B,N} bzw. R_{v,C,1} und R_{v,D,1} ... R_{v,C,M} und R_{v,D,M} einen Spannungsteiler, so dass sich durch geeignete Wahl der Widerstände ein quadratisch kodiertes Potential in den Netzen N_{S,h,1} ... N_{S,h,N} bzw. N_{S,v,1} ... N_{S,v,M} einstellt.

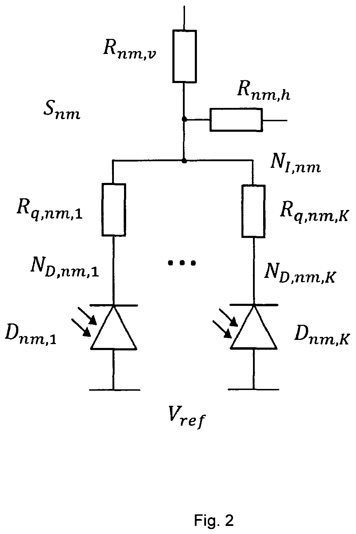

Figur 2 zeigt ein Pixel des Sensorchips einer zweiten Ausführungsform. Die zu einem Pixel gehörenden Photodioden haben die Bezeichnung D_{nm,1} ...,D_{nm,K}. An diese Photodioden D_{nm,1} ..., D_{nm,K} sind Netze N_{D,nm,1} ..., N_{D,nmK} angeschlossen, die in die jeweils zugehörigen Quenchwiderstände R_{q,nm,1}...R_{q,nm,K} münden. Von den Quenchwiderständen R_{q,nm,1}..., R_{q,nm,K} führt ein Netz N_{l,nm} ab, welches in einen Stromteiler Sₙₘ. führt. Der Index K bedeutet in allen Abkürzungen die Anzahl der Mikrozellen, die einem Stromteiler Sₙₘ zugeführt werden. Der Stromteiler Sₙₘ beinhaltet die Widerstände R_{nm,v} und R_{nm,h}, welche in die in der Zeichnung nicht dargestellten Netze N_{S,v,m} und N_{S,h,n} münden.

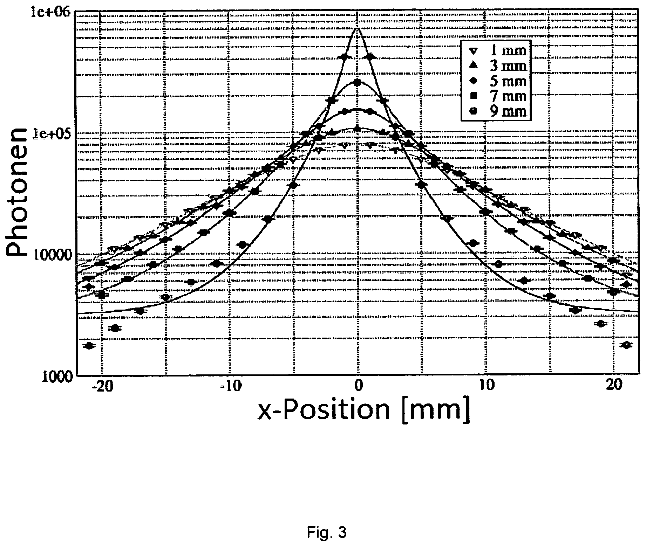

Figur 3 zeigt, die Verteilung der Photonen eines Szintillationsprozesses für eine x-Achse stellvertreten für eine beliebige Achse auf Grund rotationssymmetrischer Verteilung im Einkristall, bei der die Abszisse die Lichtverteilung um die Position Null [mm] beschreibt. Die Ordinate bezeichnet die Anzahl der Photonen als absolute Zahl.

Die mit den Symbolen Punkt, Quadrat, Raute, nach oben spitzes Dreieck und nach unten spitzes Dreieck bezeichneten Kurven, stellen die Lichtverteilung in Anhängigkeit von der Eindringtiefe des y-Quants in den Szintillationskristall dar.

Die Symbole entsprechen den folgenden Eindringtiefen der β⁺β⁻ Annihilationsstrahlung in den Szintillations-Einkristall:

| | |
|---|---|
| Punkt: | 9mm |
| Quadrat: | 7 mm |
| Raute: | 5mm |
| Nach oben spitzes Dreieck: | 3mm |
| Nach unten spitzes Dreieck: | 1 mm |

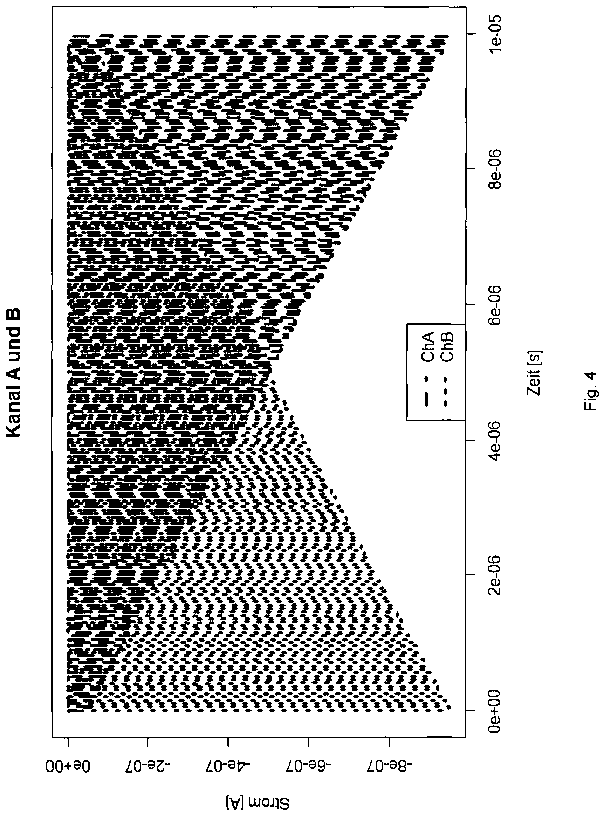

Figur 4 zeigt die Ausgangssignale der positionskodierten Kanäle stellvertretend dargestellt durch die Kanäle A und B. Die Abszisse zeigt die Zeit in Sekunden. Die Ordinate zeigt den Ausgangsstrom der A und B in [A]. In der Zeitabfolge von 0 bis 10 µs sind jeweils Photodioden einer x-Position für 50 ns aktiv. Nach Aktivierung einer Mikrozelle folgt eine Pause von 50 ns nach deren Pause die in x-Richtung nächstfolgende Mikrozelle aktiviert wird. Die Figur zeigt die Verteilung des Photostroms einer Mikrozelle über die Kanäle A und B. Da das Verhältnis für jede x-Position unterschiedlich ist, lässt sich die Position einer jeden Mikrozelle über die beiden Ausgangskanäle bestimmen.

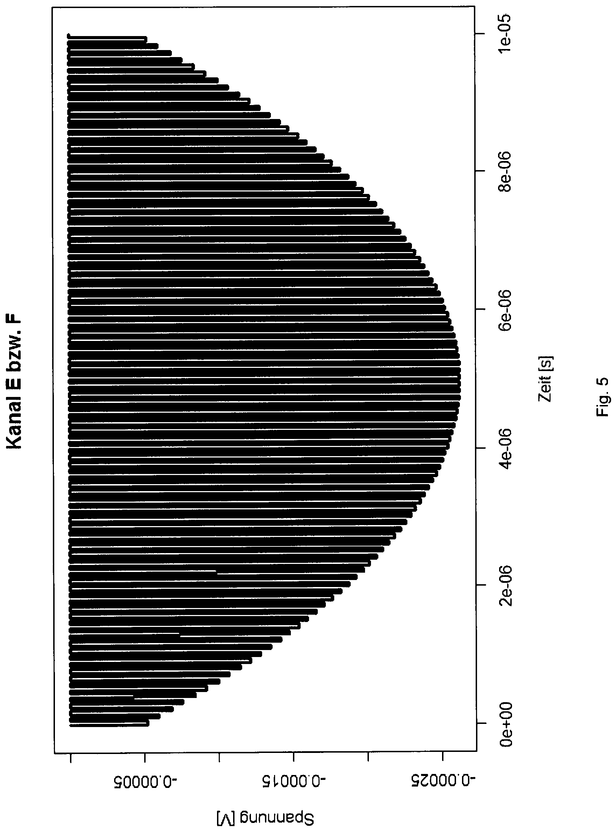

Figur 5 zeigt die Ausgangsspannung am Operationsverstärker der Kanäle E und F. Die Abszisse zeigt die Zeit in Sekunden. Die Ordinate zeigt die Ausgangsspannung der Kanäle E und F in [V]. In der Zeitabfolge von 0 bis 10 µs sind jeweils Photodioden einer x- bzw. y-Position für 50 ns aktiv. Nach Aktivierung einer Mikrozelle folgt eine Pause von 50 ns nach deren Pause die in x- bzw. y-Richtung nächstfolgende Mikrozelle aktiviert wird. Die Figur zeigt die quadratische Verteilung der Spannung abhängig von der x- bzw. y- Position einer Mikrozelle über die Kanäle E bzw. F. Hierbei wird für den summierenden Verstärker über die entsprechenden Widerstände ein Verstärkungsfaktor von eins eingestellt.

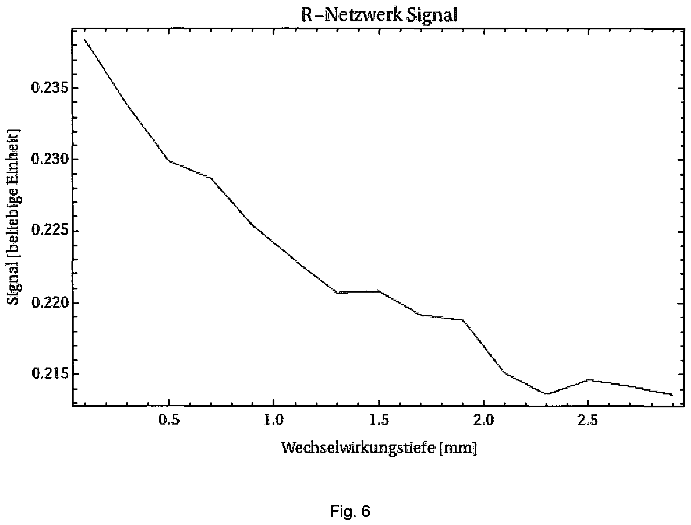

Figur 6 zeigt das Ausgangssignal des Summierernetzwerkes in Abhängigkeit von der Wechselwirkungstiefe im im xy-Zentrum des Szintillations-Einkristalls. Die Abszisse zeigt die Wechselwirkungstiefe in [mm]. Die Ordinate zeigt das Ausgangssignal des Summierernetzwerks in einer beliebigen Einheit. Mit Hilfe des Netzwerksignals lässt sich die Interaktionstiefe im xy-Zentrum des Kristalls bestimmen, da dort das erste Monet gleich null ist und deshalb die Interaktionstiefe ausschließlich über das 2. Moment bestimmt werden kann.

Zitierter Stand der Technik:
[1]: Gola, A., et al., "A Novel Approach to Position-Sensitive Silicon Photomultipliers: First Results".
[2]: Schulz, V., et al., "Sensitivity encoded silicon photomultiplier-a new sensor for high-resolution PET-MRI." Physics in medicine and biology 58.14 (2013): 4733.
[3]: Fischer, P., Piemonte, C., "Interpolating silicon photomultipliers", NIMPRA, Nov. 2012.
[4]: Espana, S., et al., "DigiPET: sub-millimeter spatial resolution small-animal PET imaging using thin monolithic scintillators".
[5]: Lerche, Ch. W., et al., "Depth of interaction detection for y-ray imaging".
[6]: US7476864 (B2).
[7]: Ito, M., et al., "Positron Emission Tomography (PET) Detectorts with Depth-of-Intercation (DOI) Capability".
[8]: Judenhofer, M. S., et al., "Simultaneous PET-MRI: a new approach for functional and morphological imaging".
[9]: Ziegler, S. I., et al., "A prototype high-resolution animal positron tomograph with avalanche photodiode arrays and LSO crystals".
[10]: Balcerzyk, M., et al., "Preliminary performance evaluation of a high resolution small animal PET scanner with monolithic crystals and depth-of-interaction encoding".
[11]: Balcerzyk, M., et al., "Initial performance evaluation of a high resolution Albira small animal positron emission tomography scanner with monolithic crystals and depth-of-interaction encoding from a user's perspective".
[12]: Gonzalez Martinez, A. J., et al., "Innovative PET detector concept based on SiPMs and continuous crystals".
[13]: Siegel, S., et al., "Simple Charge Division Readouts for Imaging Scintillator Arrays using a Multi-Channel PMT".
[14]: McElroy, D. P., et al., "First Results From MADPET-II: A Novel Detector and Readout System for High Resolution Small Animal PET".
[15]: Berneking, A., "Characterization of Sensitivity encoded Silicon Photomultiplier for high resolution simultaneous PET/MR Imaging", Diploma thesis, RWTH Aachen University, 3.12.2012.

## Patentansprüche

1. SiPM-Sensorchip mit einer Vielzahl von Pixeln, bestehend aus mindestens einer Photodiode, mindestens einem Quenchwiderstand und einem Stromteiler, der den Photostrom der Photodioden in zwei gleich große Ströme teilt, wobei die Pixel in einem Raster angeordnet sind, in dem jedes Pixel eine xy-Position in Reihen entlang einer x-Richtung und y-Richtung hat und der SiPM-Sensorchip N Reihen in x-Richtung xₙ = x₁, x₂, x₃, ...x_{N} mit n = 1, 2., ...N und M Reihen in Y-Richtung yₘ = y₁, y₂, y₃... y_{M} mit m = 1, 2, ...M, enthält, wobei x für eine horizontale Richtung h und y für eine vertikale Richtung v kodiert, **dadurch gekennzeichnet,**
**dass** der Stromteiler S_{q,nm} bzw. S_{nm,} in Netze N_{S,h,n} und N_{S,v,m} mündet, die jeweils in weitere Stromteiler S_{h,n} und S_{v,m} führen, die Kodierwiderstände R_{h,A,n} und R_{h,B,n} bzw. R_{v,C,m} und R_{v,D,m} aufweisen, die linear kodiert sind und die in die Ausgangskanäle A, B, C, D münden, wobei die Stromteiler S_{q,nm} und S_{nm,} die Netze N_{S,h,n} und N_{S,v,m}, die Stromteiler S_{h,n} und S_{v,m,} die Kodierwiderstände R_{h,A,n} und R_{h,B,n} bzw. R_{v,C,m} und R_{v,D,m} und die Ausgangskanäle A, B, C, D Teil des Sensorchips sind und dass die Netze N_{S,h,n} in ein Summiernetzwerk Oₕ und/oder die Netze N_{S,v,m} in ein Summiernetzwerk Oᵥ führen, in denen die Signale der Netze N_{S,h,n} und/oder N_{S,v,m} über Summiererwiderstände R_{S,h,n} bzw. R_{S,v,m} zusammengeführt werden und in die Ausgangskanäle E und/oder F führen, und dass die Kodierwiderstandswerte der Kodierwiderstände R_{h,A,n} und R_{h,B,n} welche die x-Richtung kodieren und an die Ausgangskanäle A und B angeschlossen sind in auf- und absteigender Weise entgegengesetzt linear kodiert sind und die Kodierwiderstandswerte der Kodierwiderstände R_{v,C,m} und R_{v,D,m} welche die y-Richtung kodieren und an die Ausgangskanäle C und D angeschlossen sind in auf- und absteigender Weise entgegengesetzt linear kodiert sind.

2. SiPM-Sensorchip nach Anspruch 1
**dadurch gekennzeichnet,**
**dass** die Summiernetzwerke Oₕ und/oder Oᵥ jeweils einen Operationsverstärker OPₕ bzw. OPᵥ der über Operationsverstärkerwiderstände R_{S,h} und R_{S,v} negativ rückgekoppelt ist, enthalten.

3. SiPM-Sensorchip nach Anspruch 1 oder 2,
**dadurch gekennzeichnet,**
**dass** die Summiererwiderstände R_{S,h,n} und/oder R_{S,v,m} im SiPM-Sensorchip integriert sind.

4. SiPM-Sensorchip nach Anspruch 3,
**dadurch gekennzeichnet,**
**dass** die Summiernetzwerke Oₕ und/oder Oᵥ in den SiPM-Sensorchip integriert sind.

5. SiPM-Sensorchip nach einem der Ansprüche 1 bis 4,
**dadurch gekennzeichnet,**
**dass** ein Pixel aus einer Photodiode Dₙₘ mit einem Stromteiler S_{q,nm} mit zwei Quenchwiderständen R_{q,nm,h} und R_{q,nm,v} besteht.

6. SiPM-Sensorchip nach einem der Ansprüche 1 bis 5,
**dadurch gekennzeichnet,**
**dass** ein Pixel aus mindestens einer Photodiode D_{nm,k} mit jeweils eigenen Quenchwiderständen R_{q,nm,k} mit k = 1, 2, 3,... K, und einem Netz N_{l,nm}, welches zu einem Stromteiler S_{nm,} bestehend aus den Widerständen R_{nm,v} und R_{nm,h,} führt, besteht.

7. SiPM-Sensorchip nach einem der Anspüche 1 bis 6,
**dadurch gekennzeichnet,**
**dass** er Pixel nach Anspruch 5 und nach Anspruch 6 enthält.

8. SiPM-Sensorchip nach einem der Ansprüche 1 bis 7,
**dadurch gekennzeichnet,**
**dass** die Potentiale an den Netzen N_{S,h,n} und/oder N_{S,v,m} quadratisch kodiert sind.

9. SiPM-Sensorchip nach einem der Ansprüche 1 bis 8,
**dadurch gekennzeichnet,**
**dass** die Pixel in Reihen in x-Richtung und Reihen in y-Richtung angeordnet sind, wobei die Reihen x und y in einem Winkel < 90° zueinander geneigt sind, sodass sich ein Rautenmuster ergibt.

10. Si-PM-Sensorchips nach einem der Ansprüche 8 bis 9,
**dadurch gekennzeichnet,**
**dass** mehrere Sensorchips zu einem Block a x b in einem Raster angeordnet sind, wobei sich die lineare Positionskodierung sowie die quadratische Kodierung der Potentiale sensorübergreifend über mehrere Sensorchips in die Richtungen a und b erstreckt.

11. SiPM-Sensorchip nach einem der Ansprüche 1 bis 10,
**dadurch gekennzeichnet,**
**dass** der Sensorchip eine Mehrzahl von J Blöcken mit Blöcken j = 1 ... J aufweist, die jeweils nach den Ansprüchen 1 bis 10 ausgestaltet sind und der Sensorchip eigene Ausgangskanäle Aⱼ, Bⱼ, Cⱼ und Dⱼ sowie Eⱼ und/oder Fⱼ für jeden Block j besitzt.

## Claims

1. A SiPM sensor chip having a plurality of pixels, consisting of at least one photodiode, at least one quench resistor and a current divider which divides the photocurrent of the photodiodes in two equally large currents, wherein the pixels are arranged in a grid in which each pixel has an xy-position in rows along an x-direction and an y-direction and the SiPM sensor chip contains N rows in the x-direction xₙ = x₁,x₂, x₃, ...x_{N} with n = 1, 2, ...N and M rows in the y-direction yₘ = y₁, y₂, y₃... yₘ with m = 1, 2, ...M, wherein x codes for a horizontal direction h and y codes for a vertical direction v, **characterized in that** the current divider S_{q,nm} and Sₙₘ, respectively, opens into networks N_{s.h,n} and N_{S,v,m} which each lead into further current dividers S_{h,n} and S_{v,m}, which have coding resistors R_{h,A,n} and R_{h,B,n} as well as R_{v.C,m} and R_{v.D.m}, respectively, which are linearly coded and which open into the output channels A, B, C, D, wherein the current dividers S_{q,nm} and S_{nm,} the networks N_{S,h,n} and N_{s,v,m}, the current dividers S_{h,n} and S_{v,m}, the coding resistors R_{h.A,n} and R_{h,B,n} as well as R_{v,C,m} and R_{v,D.m}, respectively, and the output channels A, B, C, D are part of the sensor chip and that the networks N_{S,h,n} lead into a summing network Oₕ and/or the networks N_{s,v.m} lead into a summing network Oᵥ, in which the signals of the networks N_{S,h,n} and/or N_{S,v,m} are merged via summing resistors R_{S,h,n} and R_{S,v,m}, respectively, and lead into the output channels E and/or F, and that the coding resistor values of the coding resistors R_{h,A,n} and R_{h,S,n}, which code the x-direction and are connected to the output channels A and B, are linearly coded in an ascending and descending manner in the opposite direction and the coding resistor values of the coding resistors R_{v,C,m} and R_{v,D,m}, which code the y-direction and are connected to the output channels C and D, are linearly coded in an ascending and descending manner in the opposite direction.

2. A SiPM sensor chip according to claim 1
**characterized in**
**that** the summing networks Oₕ and/or Oᵥ each contain an operational amplifier OPₕ and OPᵥ, respectively, which is negatively fed back via operational amplifier resistors R_{s,h} and R_{s,v}.

3. A SiPM sensor chip according to claim 1 or 2,
**characterized in**
**that** the summing resistors R_{s,h,n} and/or R_{s,v,m} are integrated in the SiPM sensor chip.

4. A SiPM sensor chip according to claim 3,
**characterized in**
**that** the summing networks Oₕ and/or Oᵥ are integrated into the SiPM sensor chip.

5. A SiPM sensor chip according to any one of claims 1 to 4,
**characterized in**
**that** a pixel consists of a photodiode Dₙₘ with a current divider Sq.nm with two quench resistors R_{q,nm,h} and R_{q,nm,v}.

6. A SiPM sensor chip according to any one of claims 1 to 5,
**characterized in**
**that** a pixel consists of at least one photodiode D_{nm,k} each with its own quench resistors R_{q,nm,k} with k = 1, 2, 3, ...K, and a network N_{l,nm}, which leads to a current divider Sₙₘ, consisting of the resistors R_{nm,v} and R_{nm,h}.

7. A SiPM sensor chip according to any one of claims 1 to 6,
**characterized in**
**that** it contains pixels according to claim 5 and according to claim 6.

8. A SiPM sensor chip according to any one of claims 1 to 7,
**characterized in**
**that** the potentials on the networks N_{S,h,n} and/or N_{s,v,m} are square-coded.

9. A SiPM sensor chip according to any one of claims 1 to 8,
**characterized in**
**that** the pixels are arranged in rows in the x-direction and rows in the y-direction, wherein the rows x and y are inclined to one another at an angle < 90° such that a diamond pattern results.

10. SiPM sensor chips according to any one of claims 8 to 9,
**characterized in**
**that** several sensor chips are arranged in a grid to form a block a x b, wherein the linear position coding as well as the square coding of the potentials extend over several sensor chips in the directions a and b in a sensor-overlapping manner.

11. A SiPM sensor chip according to any one of claims 1 to 10,
**characterized in**
**that** the sensor chip has a plurality of J blocks with blocks j = 1 ...J, which are each designed according to claims 1 to 10, and the sensor chip possesses its own output channels Aⱼ, Bⱼ, Cⱼ and Dⱼ as well as Eⱼ and/or Fⱼ for each block j.

## Revendications

1. Puce de capteur de photomultiplicateur en silicium, ayant une pluralité de pixels, consistant en au moins une photodiode, en au moins une résistance d'étouffement et en un diviseur de courant, qui divise le photocourant des photodiodes en deux courants de même intensité, les pixels étant disposés suivant une trame, dans laquelle chaque pixel a une position xy en rangées le long d'une direction x et d'une direction y et la puce de capteur de photomultiplicateur en silicium contient N rangées dans la direction x xₙ = x₁, X₂, x₃, ... xₙ avec n = 1, 2... N et M rangées dans la direction Y yₘ = y₁, y₂, y₃. . y_{M} avec m = 1 ,2... M, dans laquelle x code pour une direction h horizontale et y pour une direction v verticale,
**caractérisée**
**en ce que** le diviseur S_{q,nm} ou S_{nm,} de courant débouche dans des réseaux N_{S,h,n} et N_{s,v,m,}, qui conduisent chacun à d'autres diviseurs S_{h,n} et S_{v,m} de courant, qui ont des résistances R_{h,A,n} et R_{h,B,n} ou R_{v,C,m} et R_{v,D,m} de codage, qui sont codées linéairement et qui débouchent dans les canaux A, B, C, D de sortie, les diviseurs S_{q,nm} et Sₙₘ de courant, les réseaux N_{S,h,n} et N_{s,v,m}, les diviseurs S_{h,n} et S_{v,m} de courant, les résistances R_{h,A,n} et R_{h,B,n} ou R_{v,C,m} et R_{v,D,m} de codage et des canaux A, B, C, D de sortie faisant partie de la puce de capteur et **en ce que** les réseaux N_{s,h,n} conduisent à une structure Oₕ réticulée de sommation et/ou les réseaux N_{s,v,m,} conduisent à une structure Oᵥ réticulée de sommation, dans lesquelles les signaux des réseaux N_{S,h,n} et/ou N_{S,v,m} sont réunis par l'intermédiaire de résistances R_{S,h,n} et/ou R_{S,v,m} de sommation et conduisent aux canaux E et/ou F de sortie, et **en ce que** les valeurs des résistances R_{h,A,n} et R_{h,B,n} de codage, qui codent la direction x et sont raccordées aux canaux A et B de sortie, sont codées linéairement de manière opposée de façon croissante et décroissante et les valeurs des résistances R_{v,C,m} et Rv_{,D,m} de codage, qui codent la direction y et sont raccordées aux canaux C et D de sortie, sont codées linéairement de manière opposée de façon croissante et décroissante.

2. Puce de capteur de photomultiplicateur en silicium suivant la revendication 1,
**caractérisée en ce que**
les structures Oₕ et/ou Oᵥ réticulées de sommation contiennent chacune un amplificateur OPₕ ou OPᵥ opérationnel, qui est bouclé en réaction négativement par des résistances R_{S,h} et R_{S,v} d'amplificateur opérationnel.

3. Puce de capteur de photomultiplicateur en silicium suivant la revendication 1 ou 2,
**caractérisée en ce que**
les résistances R_{S,h,n} et/ou R_{S,v,m} de sommation sont intégrées à la puce de capteur de photomultiplicateur en silicium.

4. Puce de capteur de photomultiplicateur en silicium suivant la revendication 3,
**caractérisée en ce que**
les structures Oₕ et/ou Oᵥ réticulées de sommation sont intégrées à la puce de capteur de photomultiplicateur en silicium.

5. Puce de capteur de photomultiplicateur en silicium suivant l'une des revendications 1 à 4,
**caractérisée en ce que**
un pixel d'une photodiode Dₙₘ est constitué en ayant un diviseur S_{q,nm} de courant ayant deux résistances R_{q,nm,h} et R_{q,nm,v} d'étouffement.

6. Puce de capteur de photomultiplicateur en silicium suivant l'une des revendications 1 à 5,
**caractérisée en ce que**
un pixel d'au moins une photodiode D_{nm,k} est constitué en ayant respectivement ses propres résistances R_{q,nm,k} d'étouffement avec k = 1, 2, 3, ... K, et un réseau N_{l,nm,} qui conduit à un diviseur Sₙₘ, de courant consistant en les résistances R_{nm,v} et R_{nm,h}.

7. Puce de capteur de photomultiplicateur en silicium suivant l'une des revendications 1 à 6,
**caractérisée en ce que**
il contient un pixel suivant la revendication 5 et suivant la revendication 6.

8. Puce de capteur de photomultiplicateur en silicium suivant l'une des revendications 1 à 7,
**caractérisée en ce que**
les potentiels aux réseaux N_{S,h,n} et/ou N_{S,v,m} sont codés quadratiquement.

9. Puce de capteur de photomultiplicateur en silicium suivant l'une des revendications 1 à 8,
**caractérisée en ce que**
les pixels sont disposés en rangées dans la direction x et en rangées dans la direction y, les rangées x et y étant inclinées entre elles d'un angle inférieur à 90°, de manière à donner un motif en losange.

10. Puce de capteur de photomultiplicateur en silicium suivant l'une des revendications 8 à 9,
**caractérisée en ce que**
plusieurs puces de capteur sont disposées par rapport à un bloc a x b en une trame, le codage de position linéaire ainsi que le codage quadratique des potentiels s'étendant à chevauchement de capteur sur plusieurs puces de capteur dans les directions a et b.

11. Puce de capteur de photomultiplicateur en silicium suivant l'une des revendications 1 à 10,
**caractérisée en ce que**
la puce de capteur a une pluralité de J blocs ayant des blocs j = 1 ... J, qui sont conformés chacun suivant les revendications 1 à 10 et la puce de capteur possède ses propres canaux Aⱼ, Bⱼ, Cⱼ et Dⱼ de sortie ainsi que Eⱼ, et/ou Fⱼ pour chaque bloc j.
